# EUROPEAN PATENT SPECIFICATION

(11) **EP 0 536 410 B1**
(45) Date of publication and mention of the grant of the patent: **21.07.1999**
(21) Application number: 92908177.6
(22) Date of filing: 14.04.1992
(51) Int. Cl.: C03B 8/04, H01L 21/316

(54) **METHOD FOR FORMING VAPOR PHASE GROWN FILM**
VERFAHREN ZUR HERSTELLUNG EINES IN DER DAMPFPHASE GEWACHSENEN FILMES
PROCEDE DE FORMATION D'UN FILM A CROISSANCE EN PHASE VAPEUR

(30) Priority: 15.04.1991 JP 8253291
(43) Date of publication of application: 14.04.1993
(73) Proprietor: SEMICONDUCTOR PROCESS LABORATORY CO., LTD., Minato-ku, Tokyo 108 (JP); CANON SALES CO., INC., Minato-ku, Tokyo 108 (JP); ALCAN-TECH CO., INC., Tokyo 108 (JP)
(72) Inventor: MAEDA, Kazuo, Semiconductor Process Lab. Co., Ltd., Minato-ku, Tokyo 108 108 (JP); TOKUMASU, Noboru, Semiconductor Process Lab Co Ltd, Minato-ku, Tokyo 108 (JP); NISHIMOTO, Yuhko, Semiconductor Process Lab Co Ltd, Minato-ku, Tokyo 108 (JP)
(74) Representative: Marx, Lothar, Dr.
(86) International application number: PCT/JP92/00467
(87) International publication number: WO 92/18430

(56) References cited:
- EP-A- 0 060 783
- EP-A- 0 204 182
- EP-A- 0 286 097
- EP-A- 0 412 644
- JP-A- 60 090 838
- JP-A- 61 275 136
- JP-A- 63 262 844
- DATABASE WPI Derwent Publications Ltd., London, GB; AN 85-161549 & JP-A-60 090 838 (SHINETSU) 22 May 1985
- JOURNAL OF THE ELECTROCHEMICAL SOCIETY vol. 137, no. 4 , April 1990 , MANCHESTER pages 1288 - 1296 XP000126970 S.RASTANI ET AL 'low pressure chemical vapour deposition of thin film geO2-SiO2 glasses'

## Description

### BACKGROUND OF THE INVENTION

The present invention relates to a method for forming a Chemical Vapor Deposition (CVD) film and an apparatus for manufacturing a semiconductor device used in forming an interlevel insulator of a semiconductor device.

There are a variety of systems for a CVD method for forming an insulating film, but a plasma CVD method and a thermal CVD method are principally used in recent years. Incidentally, an insulating film formed by the plasma CVD method is not suitable for a highly dense and fine pattern such as a very large scale integrated circuit (VLSI), in particular a dynamic random access memory (DRAM) since such an insulating film is poor in step coverage, and is neither desirable because impurities such as carbon (C) is contained in the insulating film.

Accordingly, application of the thermal CVD method superior in step coverage, in particular the thermal CVD method which enables film formation at such a low temperature that exerts no thermal influence upon others is drawing attention for forming a VLSI such as a DRAM.

There are (a) a method of oxidizing SiH₄ or oxidizing SiH₄ after mixing PH₃ and B₂H₄ therewith, and (b) a method for pyrolyzing or oxydizing alkoxysilane Si(OR)₄ or oxydizing Si(OR)₄ after mixing B(OR)₃ and PO(OR)₃ therewith as a conventional method for forming a SiO₂ film or an insulating film with a SiO₂ film as the base by a thermal CVD method.

Now, there are those interlevel insulators that are formed between Aℓ and a gate and between Aℓ and Aℓ, and the following properties are required especially as characteristics of the forming process and the film when seeing from the device side.
For example,
① for an interlevel isolator between Aℓ and Aℓ, the following items are required.
   . The growth at a low temperature is possible.
   . The film is to be one having low stress and low damage.
   . The film is to be one that has high denseness and controls the hillock of Aℓ.
   . The film is to be one that shows stable electric characteristics.
   . The film is to be one that has flat characteristic.
   . The film is to be one that has few pin-holes.
   . The particle generation density is to be low.
   . The film is to be one that has high durability.
   Further,
② for an interlevel insulator between Aℓ and a gate, the following items are required.
   . The film is to be one that is capable of reflow at a low temperature.
   . The film is to be one that shows stable electric characteristics.
   . The film is to be one that has few pin-holes.
   . The particle generation density is to be low.

Accordingly, as a conventional method for forming an interlevel insulator between Aℓ and Aℓ, there is adopted a complicated process such that three types of a CVD film I 35, CVD film II 36 and a CVD film III 37 are formed by a plasma CVD method or an atmospheric pressure CVD method on interconnection metals 34 on a substrate 33 as shown in Fig. 8, or an applied glass film midway therebetween for flattening and etch-back is applied as shown in Fig. 9.

Further, methods for forming an interlevel insulator as described hereunder have been proposed as the method for forming an interlevel insulator between Aℓ and a gate. That is, there are provided such methods as follows.
(1) Formation of an arsenic silicate glass film using SiH₄-AsH₃-O₂.
(2) Formation of a boron silicate glass film using SiH₄-B₂H₆-PH₃-O₂.
(3) Formation of a boron arsenic silicate glass film using TEOS-Tri Methyl Borate (TMB)-Tri Methyl Phosphate (TMOP)-O₃.
(4) Formation of a boron arsenic silicate glass film using TEOS-TMB-TMOP-O₂.
(5) Formation of a germanium silicate glass film using SiH₄-GeH₄-PH₃-O₂.

However, since reflow of the interlevel insulator can be performed at a temperature of approximately 800°C to 900°C in (1) to (5), it is possible to lower the reflow temperature, which, however, is not sufficient. In particular, the reflow temperature is lowered in (2) to (4) by adding arsenic or boron, but there is such a problem that the film quality becomes unstable with the increase of the concentration of arsenic or boron.

Furthermore, according to the method for forming a germanium silicate glass film using SiH₄-GeH₄-PH₃-O₂ in (5), there is such a problem that respective compounds are hydrides which are very active and very difficult in handling in practical production, thus being unsuitable for mass production.

According to patent abstract AN 85-161549 a glass film is formed by reacting a silane ester and a dopant from phosphine, germanium alkoxide and boron alkoxide with oxygen. Similarly, EP-A-0 060 783 describes to reaction of silane, germane and phosphine (i.e. the hydrides of these elements) with oxygen under normal pressure at temperatures of 350 to 500°C.

Further, EP-A-0 412 644 discloses to react siloxane and alkoxide of phosphorus and boron with ozone under reduced pressure.

The present invention is created in view of such conventional various problems, and has for its object to provide improved method for forming a CVD film and apparatus for manufacturing a semiconductor device suitable for both formation of an interlevel insulator between Aℓ and Aℓ and formation of an interlevel insulator between Aℓ and a gate and also for mass production.

### SUMMARY OF THE INVENTION

According to a method for forming a CVD film of the present invention, firstly, an organic silane compound containing siloxane or alkoxysilane and an alkoxy compound of germanium are mixed with each other and with ozone in a vapor phase, and these compounds and ozone are then made to react with each other under atmospheric pressure, thereby to form a thin glass film composed of a two-component system of silicon oxide and germanium oxide on a substrate as defined in claim 1.

Further, an organic silane compound containing siloxane or alkoxysilane, an alkoxy compound of germanium, and one selected from the group consisting of an alkoxy compound or a mixture of alkoxy compound containing at least either phosphorus or boron, an oxide containing at least either phosphorus or boron and acid chloride containing at least either phosphorus or boron are mixed with ozone, and these compounds and ozone are made to react with each other under atmospheric pressure, thereby to form a thin glass film composed of three-component system of silicon oxide, germanium oxide and phosphorus oxide, or a thin glass film composed of three-component system of silicon oxide, germanium oxide and boron oxide, or a thin glass film composed of four-component system of silicon oxide, germanium oxide, phosphorus oxide and boron oxide on a substrate.

An apparatus for manufacturing a semiconductor device of the present invention includes means for feeding an organic silane compound containing siloxane or alkoxysilane, means for feeding an alkoxy compound of germanium, means for feeding ozone, and a reaction chamber in which the organic silane compound and the alkoxy compound are mixed in a vapor phase and these compounds and ozone are made to react to each other under atmospheric pressure, and a thin glass film is formed on a substrate in the reaction chamber.

The apparatus may further provide means for feeding an organic silane compound containing siloxane or alkoxysilane, means for feeding an alkoxy compound of germanium, means for feeding an alkoxy compound or a mixture of an alkoxy compound containing at least either phosphorus or boron, an oxide containing at least either phosphorus or boron, or acid chloride containing at least either phosphorus or boron, and a reaction chamber in which these compounds are mixed with one another and these compounds and ozone are made to react to each other under atmospheric pressure, and a thin glass film is formed on a substrate in the reaction chamber.

In the next place, the operation of the present invention will be explained in accordance with the results of experiments performed by the inventor of the present application.

The present invention is featured in that respective alkoxy compounds of silicon, phosphorus and boron are used, and an alkoxy compound of germanium is mixed with these compounds so as to react thereto, thereby to form a CVD film.

Namely, mixed gas expressed by general chemical formulas of alkoxy compounds:

Si(OR)₄

Ge(OR)₄

PO(OR)₃ or P(OR)₃

B(OR)₃

(in these formulas, R represents an alkyl group having carbon at 4 or less and a derivative thereof) is used.

Besides, a compound of a siloxane system such as chain siloxane and cyclic siloxane may be used for silicon.

The chain siloxane is expressed by the following general formula: 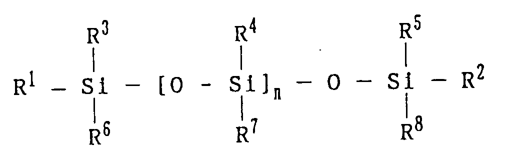 (in the formula, R¹, R², R³, R⁴, R⁵, R⁶, R⁷ and R⁸ represents an alkyl group containing carbon at 4 or less and a derivative thereof, respectively), and for example, Hexamethyldisilo (HMDS): 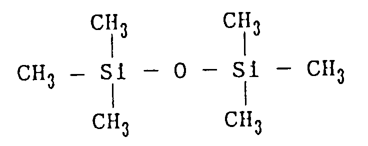 is a concrete example thereof.

Further, the cyclic siloxane is expressed by the following general formula: 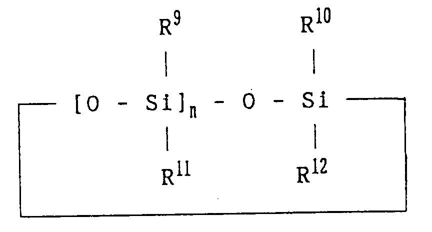 (in the formula, R⁹, R¹⁰, R¹¹ and R¹² represent an alkyl group containing carbon at 4 or less and a derivative thereof, respectively), and for example, Octamethylcyclotetrasiloxane (OMCTS): 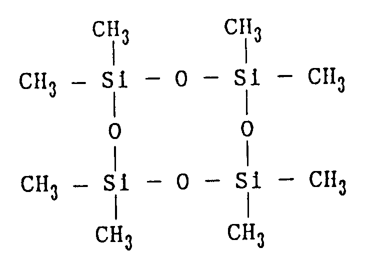 is a concrete example thereof.

It become possible with these compounds to form a low temperature CVD glass film at a temperature up to 400°C by adding O₃.

In the experiments performed by the inventor of the present invention, a thin glass film composed of two-component system of SiO₂-GeO₂ was formed on a substrate by a low temperature CVD reaction under atmospheric pressure at 400°C through the reaction of Si(OR)₄-Ge(OR)₄-O₃ system. As a result, it has been found that the refractive index, the stress, the density and the like of a thin glass film depend on the added quantity of GeO₂.

In particular, when GeO₂ was added to the extent that 40% (mol ratio) is not exceeded, a film having such an excellent property as an interlevel insulator that:
. cracking limit is increased,
. Aℓ hillock is prevented from generating,
. self-flatness is increased,
. the density of the film is increased, and
. the stress is small,
as compared with a conventional film of SiO₂ only could be formed.

As described above, the mixed glass film of SiO₂ added with GeO₂ and GeO₂ obtained in the present invention shows stable physical properties. It is conceivable that the film after formation has already a glass network construction since a mixed glass film is formed using an organic source as the compound source, and thus, a more stable film has been formed.

However, when GeO₂ exceeds 50% (mol ratio), the water resisting property of the film tends to deteriorate. Therefore, it is required to be cautious so that the addition quantity of GeO₂ is not increased too much.

Further, a thin glass film (a GBPSG film) composed of a four-component system was formed on a substrate by adding PO(OR)₃ and B(OR)₃ to the Si(OR)₄-Ge(OR)₄-O₃ system and by low temperature CVD reaction under atmospheric pressure at 400°C.

In this case, although it depends on the addition quantity of phosphorus, the reflow temperature falls by about 100°C as compared with a conventional BPSG film added with no germanium, and sufficient reflow was obtainable at 700 to 800°C.

With the foregoing, it is conceived that the softening point of PSG has fallen by adding GeO₂, but it is very effective if such a film is applied to the interlevel insulator between Aℓ interconnection and the gate in a device of high density such as a DRAM requiring good coverage and aiming at low temperature processing.

### BRIEF DESCRIPTION OF THE DRAWINGS

Fig. 1 is an explanatory drawing of an apparatus for forming an atmospheric pressure CVD film according to an embodiment of the present invention;
Fig. 2 is an explanatory drawing of an apparatus for forming an atmospheric pressure CVD film according to an embodiment of the present invention;
Fig. 3 shows explanatory drawings of a method for manufacturing a semiconductor device according to an embodiment of the present invention;
Fig. 4 is a diagram showing the relationship between the liquid temperature and the vapor pressure of an alkoxy compound as a silicon source;
Fig. 5 is a diagram showing the relationship between the liquid temperature and the vapor pressure of an alkoxy compound as a germanium source;
Fig. 6 is an explanatory table showing the results of investigation on the deposition rate, the composition ratio, the refractive index and the stress of a film formed by a method of the present invention;

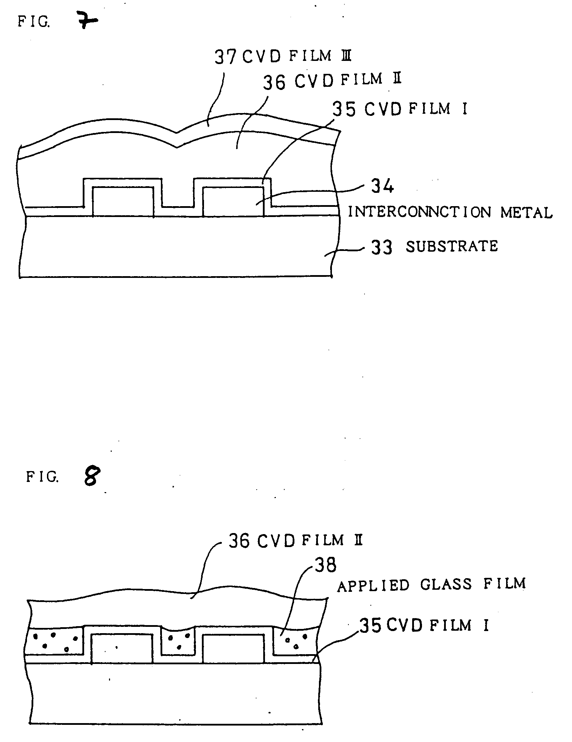

Fig. 7 is an explanatory drawing (-1) of a conventional example; and
Fig. 8 is an explanatory drawing (-2) of a conventional example.

### DESCRIPTION OF THE PREFERRED EMBODIMENTS

An embodiment of the present invention will be described hereinafter with reference to the drawings.

### (1) Description of an apparatus for forming an atmospheric pressure CVD film according to an embodiment of the present invention

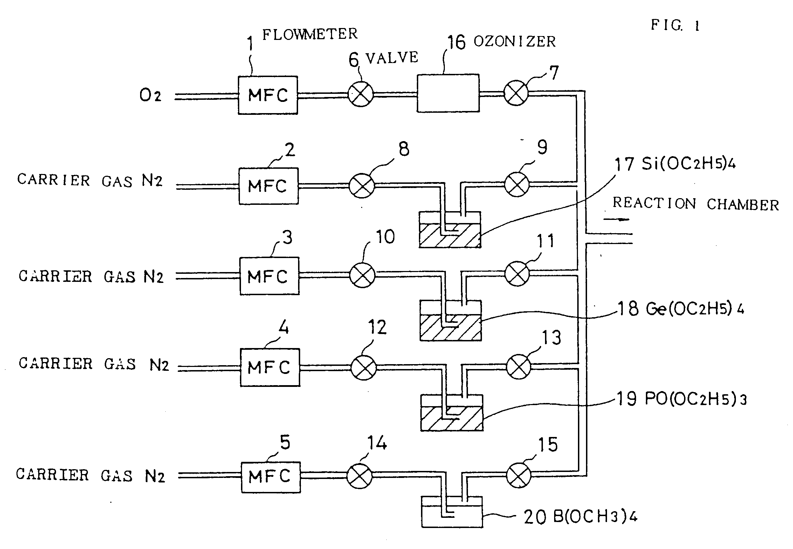

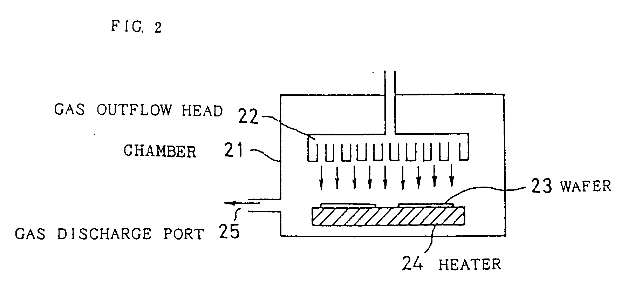

Fig. 1 is a schematic block diagram showing an apparatus for mixing respective reaction gases used for a method for forming an atmospheric pressure CVD film according to an embodiment of the present invention, and Fig. 2 is a schematic block diagram showing a reaction apparatus for introducing mixed reaction gas into a chamber so as to form a CVD thin glass film.

In Fig. 1, reference numerals 1 to 5 represent flowmeters (MFC), 6 to 15 represent valves, and 16 represents an ozonizer for changing oxygen (O₂) to ozone (O₃). 17 represents liquid Si(OC₂H₅)₄ as a silicon source, 18 represents liquid Ge(OC₂H₅)₄ as a germanium source, 19 represents liquid PO(OC₂H₅)₃ as a phosphorus source, and 20 represents liquid B(OCH₃)₃ as a boron source, and respective liquids are set to specific temperatures suitable for reaction, respectively.

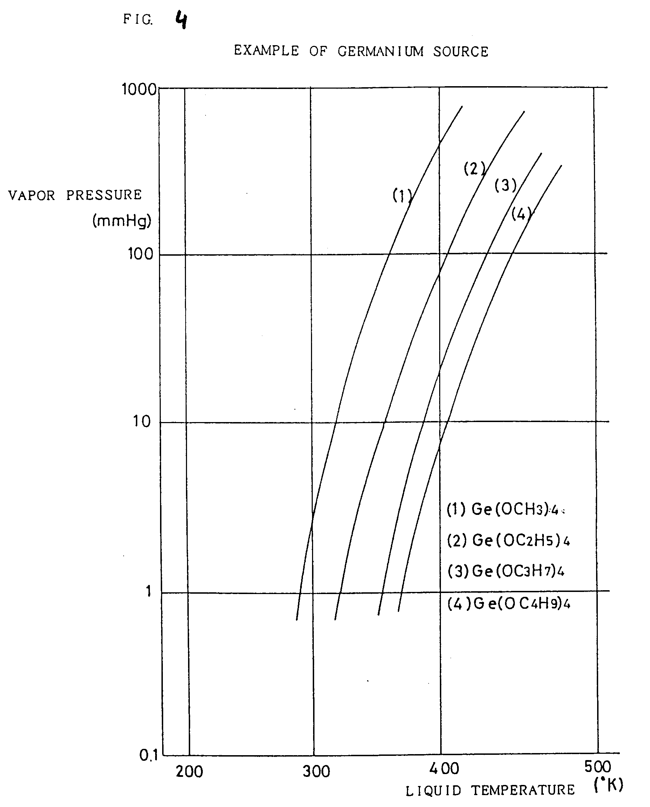

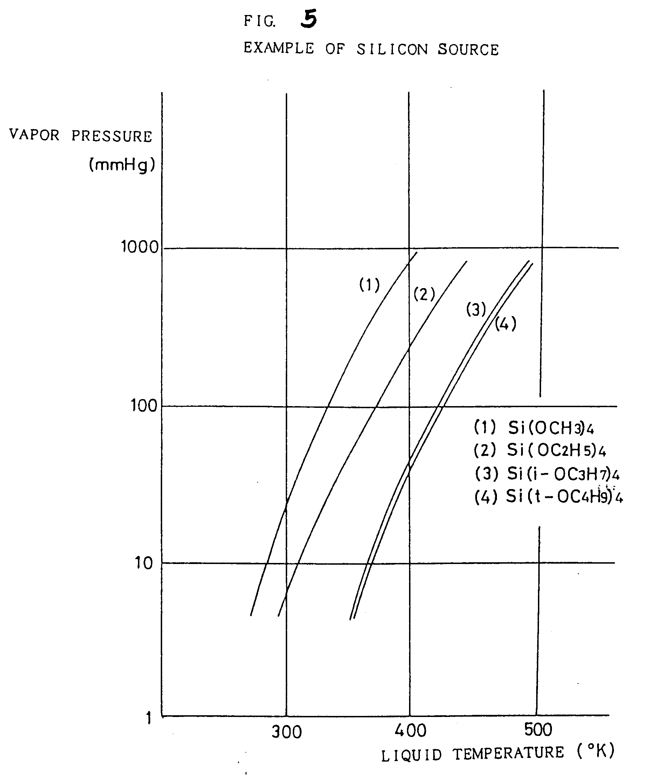

Fig. 4 shows the relationship between liquid temperatures and vapor pressures of various alkoxy compounds as the silicon source, and Fig. 5 shows the relationship between liquid temperatures and vapor pressures as the germanium source. As shown in these figures, it is possible to set the vapor pressures of respective gases by controlling the liquid temperature, thus making it possible to adjust the composition ratio of SiO₂-GeO₂ and the deposition rate.

Further, in Fig. 2, 21 represents a chamber as a gas reaction chamber, 22 represents a gas outlet head for introducing the mixed gas onto a wafer surface in the chamber, 23 represents a wafer, 24 represents a heater for setting the wafer 23 at a predetermined temperature, and 25 represents a gas discharge port.

### (2) Description of a method for forming an atmospheric pressure CVD film according to an embodiment of the present invention

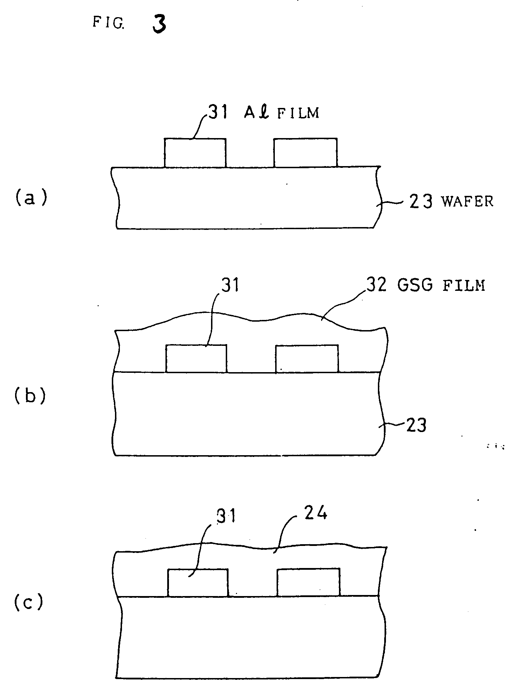

Next, a method for forming an atmospheric pressure CVD film according to an embodiment of the present invention using the apparatus shown in Fig. 1 and Fig. 2 will be described with reference to manufacturing process drawings for a semiconductor device shown in Fig. 3. Besides, the wafer 23 shown in Fig. 3(a) is the same as the wafer 23 shown in Fig. 2, and Aℓ interconnections 31 in a lower layer are formed on the wafer 23.
① First, a case that a Germanosilicate Glass (GSG) film is formed on the wafer 23 will be described.
   When a GSG film is formed on the wafer 23, the temperature of the wafer is set to 400°C by the heater 24, and oxygen (O₂) at 3 standard liter/min (3SLM) is fed by opening the valves 6 and 7 so as to generate ozone (O₃) at the percentage of content of 4% (O₃/O₂) from the ozonizer 16. Further, the valve 8 is opened so as to feed carrier gas N₂ at 4SLM to Si(OC₂H₅)₄ (silicon source) 17 which is set to the liquid temperature at 65°C, thereby to generate gasified Si((OC₂H₅)₄ through the valve 9. Furthermore, the valve 10 is opened so as to feed carrier gas N₂ at 1LSM to Ge(OC₂H₅)₄ which is set to the liquid temperature at 60°C, thereby to generate gasified Ge(OC₂H₅)₄. Then, these gases are led toward the reaction chamber 21 while mixing these gases with each other, and discharged from the gas outflow head 22 onto the surface of the wafer 23.
   With this, as shown in Fig. 3(b), Si(OC₂H₅)₄ gas and Ge(OC₂H₅)₄ gas surface-react with ozone on the wafer, and grow on the wafer surface at a deposition rate of a film forming rate at 1,000 Å/min. The refractive index of a film deposited at this time was 1.48. Further, the composition of the film included SiO₂ at 50 mol % and GeO₂ at 20 mol %.
   As described above, according to a method for forming a CVD film related to an embodiment of the present invention, a CVD film can be formed at a low temperature of 400°C. Thus, it is possible to reduce thermal stress applied to the Aℓ film 31 in a lower layer, and to prevent the film quality from changing. Further, since the step coverage is also good, such complicated processes as that a plurality of CVD films are put one upon another or etch back are not required. Thus, it is possible to aim at simplification of a process for forming an interlevel insulator.
   In particular, when it is required to improve the step coverage, it is possible to aim at further improvement of the step coverage by containing phosphorus or boron by the methods for forming the film described in the following paragraphs ② and ③.
② Namely, when a Germano-Phospho-Silicate Glass (GPSG) film is formed on the wafer 23, the valves 12 and 13 are opened further so as to also feed PO(OR)₃ into the chamber 21, thereby to have ozone react on Si(OC₂H₅)₄, Ge(OC₂H₅)₄ and PO(OC₂H₅)₃ to deposit a GPSG film on the wafer.
③ Further, when a Germanoborophosphosilicate Glass (GBPSG) film is formed on the wafer 23, all the valves 6 to 15 are opened so as to lead ozone, Si(OC₂H₅)₄, Ge(OC₂H₅)₄, PO(OC₂H₅)₃ and B(OCH₃)₃ into the chamber 21, thereby to deposit a GBPSG film on the wafer.

Then, it is possible to aim at flattening of the whole film by applying reflow processing to the GPSG film and the GBPSG film formed by the methods described in ② and ③ as shown in the process drawing of Fig. 3(c).

The reflow temperature in this case is approximately 700 to 800°C, and it is possible to lower the temperature by about 100°C or more as compared with a conventional case.

Incidentally, in the embodiment described above, Si(OC₂H₅)₄ containing an alkyl group having the number of carbons at 2 is used as an organic silane compound containing alkoxysilane, and Ge(OC₂H₅)₄ containing an alkyl group having the number of carbons at 2 is used as an alkoxy compound of germanium. However, another alkoxysilane and alkoxy compound of germanium containing an alkyl group having the number of carbons at 4 or less may be used, or an alkoxy compound containing a derivative of an alkyl group having the number of carbons at 4 or less may either be used.

Further PO(OC₂H₅)₃ containing an alkyl group having the number of carbons at 2 and B(OCH₃)₃ containing an alkyl group having the number of carbon at 1 are used as an alkoxy compound containing phosphorus or boron, but another alkoxy compounds containing an alkyl group having the number of carbon at 4 or less may be used, or an alkoxy compound containing a derivative of an alkyl group having the number of carbons at 4 or less may either be used.

Furthermore, an organic silane compound containing alkoxysilane is used, but chain siloxane expressed by a general formula: 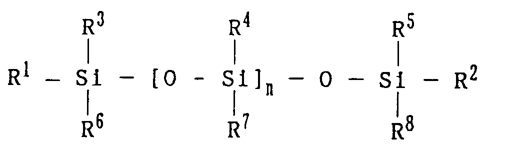 (in the formula, R¹, R², R³, R⁴, R⁵, R⁶, R⁷ and R⁸ express an alkyl group having carbon at 4 or less and a derivative thereof, respectively), and cyclic siloxane expressed by a general formula: 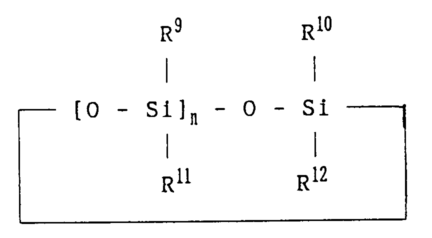 (in the formula, R⁹, R¹⁰, R¹¹ and R¹² represent an alkyl group having carbon at 4 or less or a derivative thereof) may be used.

### (3) Description of an experimental example of a method for forming an atmospheric pressure CVD film according to an embodiment of the present invention

In the experiment.
TEOS (R = C₂H₅) as the source of SiO₂,
TMB (R = CH₃) as the source of B₂O₃,
TMOP (R = C₂H₅) as the source of P₂O₅, and
Tetraethoxy germanium (TEOG) (R = C₂H₅) as the source of GeO₂
   were used, and, as the deposit conditions of a film:
   the deposition temperature was set to 400°C, the O₃ concentration was set to 4%, and the temperature/flow rate of respective sources were set to:
      65°C/3.0SLM for TEOS,
      10°C/0.13SLM for TMB,
      60°C/1.8SLM for TMOP, and
      60°C/0, 1, 2, 3, 4SLM for TEOG,
         thereby to form five types of films, and the deposition rate, the composition ratio, the refractive index and the stress were measured with respect to each film.

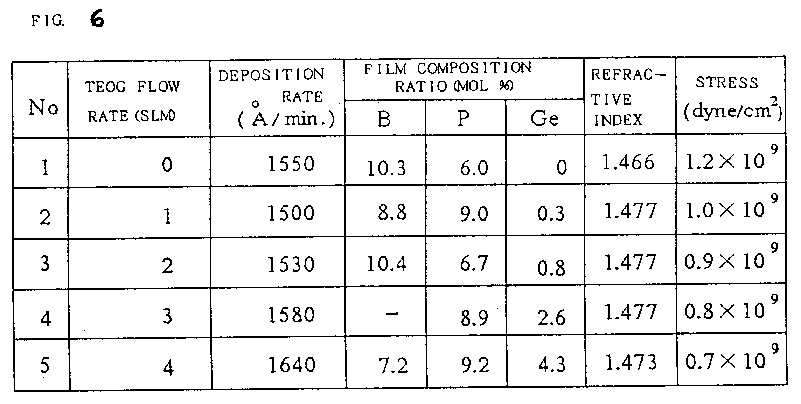

As the result, the data shown in Fig. 6 were obtained. Besides, the composition ratio (mol %) was measured by Inductively Coupled Plasma Emission Spectrometry (ICP method), and the stress was measured on a film in a state as deposited.

Thus, it is understood that the stress of a film is reduced and the refractive index is increased with the addition of GeO₂.

As described above, according to the method for forming a CVD film of the present invention, it is possible to aim at lowering of the temperature for film formation processing as compared with a conventional method of formation. Thus, the method of the present invention is optimum for forming an interlevel insulator between Aℓ and Aℓ of a semiconductor device and for forming an interlevel insulator between Aℓ and a gate.

Further, since an organic compound such as an organic silane compound containing siloxane or alkoxysilane, an alkoxy compound of germanium and an alkoxy compound containing at least either phosphorus or boron is used as a source of a CVD film, this method is easy in handling and suitable for mass production.

Furthermore, the softening point of the PSG film falls by containing GeO₂ in the CVD film (glass film). Thus, it becomes possible to lower the reflow temperature for flattening the film, and to reduce the influence of the temperature stress on the gate (polysilicon film, polycide film and the like) and the interconnection (Aℓ film and the like). Further, the film quality also being good, it is possible to aim at manufacturing of a semiconductor device of high density, high fineness and high reliability. Effects of the Invention

As described above, the method for forming a CVD film for manufacturing a semiconductor device according to the present invention are optimum for forming an interlevel insulator between Aℓ and Aℓ of a semiconductor device and forming an interlevel insulator between Aℓ and a gate thereof, and are also easy in handling and suitable for mass production.

Furthermore, the film quality also being good, these method is useful as a method for manufacturing for manufacturing a semiconductor device of high density, high fineness and high reliability.

### Description of Reference Numerals

1 - 5 ... flowmeters; 6 - 15 ... valves; 16 ... ozonizer; 17 ... Si(OC₂H₅)₄; 18 ... Ge(OC₂H₅)₄; 19 ... PO(OC₂H₅)₃; 20 ... B(OCH₃)₃; 21 ... chamber; 22 ... gas outflow head; 23 ... wafer; 24 ... heater; 25 ... gas discharge port; 31 ... Aℓ film; 32 ... GSG film.

## Claims

1. A method for forming a chemical vapor deposition film, comprising the steps of:
a)mixing in a vapor phase
(1)an organic silane compound containing one selected from the group consisting of
(i)chain siloxane expressed by a general formula: 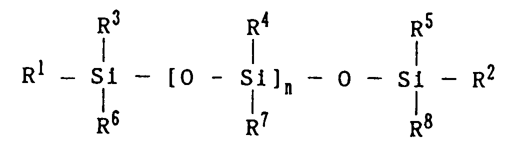 (in the formula, R¹, R², R³, R⁴, R⁵, R⁶, R⁷ and R⁸ represent an alkyl group having 4 or less carbon atoms and a derivative thereof, respectively),
(ii)cyclic siloxane expressed by a general formula: 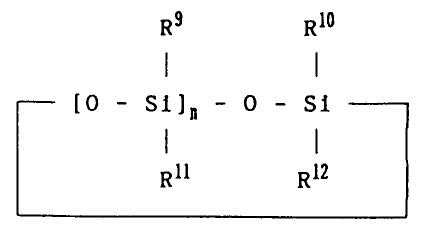 (in the formula, R⁹, R¹⁰, R¹¹ and R¹² represent an alkyl group having 4 or less carbon atoms and a derivative thereof, respectively), and
(iii)alkoxysilane expressed by a general formula:
Si(OR)₄
(in the formula, R represents an alkyl group having 4 or less carbon atoms),
(2)an alkoxy compound of germanium expressed by a general formula:
Ge(OR)₄
(in the formula, R represents an alkyl group having 4 or less carbon atoms); and
(3)ozone; and
b)introducing the mixture into the reaction chamber; and
c)reacting the compounds and ozone with each other under atmospheric pressure so as to form a thin glass film on a substrate.

2. A method according of the claim 1 whereby a thin glass film composed of silicon oxide and germanium oxide is formed on a substrate.

3. A method according of the claim 1 wherein in the mixing step, one selected from the group consisting of
(i) an alkoxy compound containing phosphorus, boron, or both of phosphorus and boron,
(ii) an oxide containing phosphorus, boron, or both of phosphorus and boron, and
(iii) an acid chloride containing phosphorus, boron, or both of phosphorus and boron
is mixed with said organic silane compound and said alkoxy compound of germanium.

4. A method according of the claim 3 wherein said alkoxy compound containing phosphorus, boron, or both of phosphorus and boron is an alkoxy compound expressed by a general formula PO(OR)₃ or P(OR)₃, an alkoxy compound expressed by a general formula B(OR)₃, or a mixture of these alkoxy compounds (in these formulas, R represents an alkyl group having carbon at 4 or less and a derivative thereof).

5. A method according of the claim 3 whereby a thin glass film composed of silicon oxide, germanium oxide and boron oxide is formed on a substrate.

6. A method according of the claim 3 whereby a thin glass film composed of silicon oxide, germanium oxide and phosphorous oxide is formed on a substrate.

7. A method according of the claim 3 whereby a thin glass film composed of silicon oxide, germanium oxide, boron oxide and phosphorous oxide is formed on a substrate.

## Patentansprüche

1. Verfahren zur Bildung eines Films mittels chemischer Dampfabscheidung (CVD-Film), umfassend die Schritte:
a) Mischen in einer Dampfphase von
(1) einer organischen Silanverbindung, enthaltend ein Element, das aus der Gruppe gewählt ist, die besteht aus
(i) einem Kettensiloxan entsprechend der allgemeinen Formel: 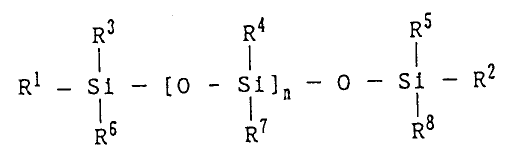 (in der Formel stehen die Reste R¹, R², R³, R⁴, R⁵, R⁶, R⁷ und R⁸ für eine Alkylgruppe mit 4 oder weniger Kohlenstoffatomen bzw. ein Derivat derselben),
(ii) einen zyklischen Siloxan, entsprechend der allgemeinen Formel: 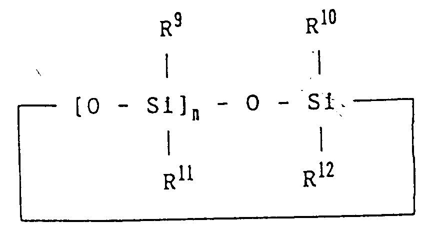 (in der Formel stehen die Reste R⁹, R¹⁰, R¹¹ und R¹² für eine Alkylgruppe mit 4 oder weniger Kohlenstoffatomen bzw. ein Derivat derselben) und
(iii) einen Alkoxysilan, entsprechend der allgemeinen Formel:
Si(OR)₄
(in der Formel steht R für eine Alkylgruppe mit 4 oder weniger Kohlenstoffatomen),
(2) einer Alkoxyverbindung des Germaniums entsprechend der allgemeinen Formel
Ge(OR)₄
(in der Formel steht R für eine Alkylgruppe mit 4 oder weniger Kohlenstoffatomen) und
(3) Ozon;
b) Einführung der Mischung in die Reaktionskammer; und
c) Umsetzen der Verbindungen und Ozon miteinander unter atmosphärischen Druck zur Bildung eines dünnen Glasfilms auf einem Substrat.

2. Verfahren gemäß Anspruch 1, wodurch ein dünner Glasfilm, zusammengesetzt aus Siliziumoxid und Germaniumoxid, auf einem Substrat gebildet wird.

3. Verfahren gemäß Anspruch 1, worin während des Mischschrittes ein Element, das aus der Gruppe ausgewählt ist, die besteht aus:
(i) einer Alkoxyverbindung, enthaltend Phosphor oder sowohl Phosphor und Bor,
(ii) ein Oxid, enthaltend Phosphor oder Bor oder sowohl Phosphor und Bor,
(iii) ein Säurechlorid enthaltend Phosphor, Bor oder sowohl Phosphor und Bor,
mit der organischen Silanverbindung und der Alkoxyverbindung des Germaniums gemischt wird.

4. Verfahren gemaß Anspruch 3, worin die Alkoxyverbindung enthaltend Phosphor, Bor oder sowohl Phosphor und Bor, eine Alkoxyverbindung entsprechend der allgemeinen Formel PO(OR)₃ oder P(OR)₃, eine Alkoxyverbindung entsprechend der allgemeinen Formel B(OR)₃ oder eine Mischung dieser Alkoxyverbindungen darstellt (in diesen Formeln steht R für eine Alkylgruppe mit 4 oder weniger Kohlenstoffatomen und ein Derivat derselben).

5. Verfahren gemäß Anspruch 3, wodurch ein dünner Glasfilm, zusammengesetzt aus Siliziumoxid, Germaniumoxid und Boroxid, auf einem Substrat gebildet wird.

6. Verfahren gemaß Anspruch 3, wodurch ein dünner Glasfilm, zusammengesetzt aus Siliziumoxid, Germaniumoxid und Phosphoroxid, auf einem Substrat gebildet wird.

7. Verfahren gemäß Anspruch 3, wodurch ein dünner Glasfilm, zusammengesetzt aus Silizumoxid, Germaniumoxid, Boroxid und Phosphoroxid, auf einem Substrat gebildet wird.

## Revendications

1. Procédé de formation d'un film par dépôt chimique en phase vapeur, comprenant les étapes consistant :
a) à mélanger en phase vapeur
(1) un composé organosilane choisi dans le groupe constitué par
(i) un siloxane à chaîne linéaire, ayant la formule générale 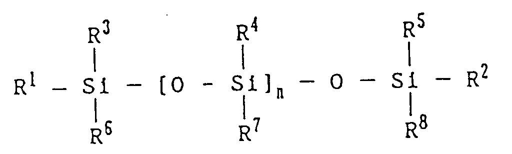 (dans laquelle, R¹, R², R³, R⁴, R⁵, R⁶, R⁷ et R⁸ représentent un groupe alkyle ayant au plus 4 atomes de carbone, et un dérivé de celui-ci, respectivement),
(ii) un siloxane cyclique ayant la formule générale 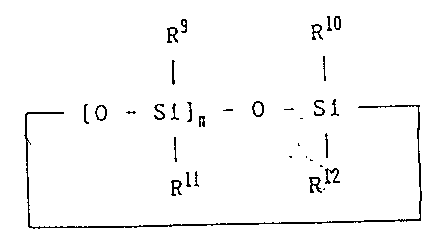 (dans laquelle, R⁹, R¹⁰, R¹¹ et R¹² représentent un groupe alkyle ayant au plus 4 atomes de carbone, et un dérivé de celui-ci, respectivement), et
(iii) un alcoxysiloxane ayant la formule générale :
Si(OR)₄
(dans laquelle, R représente un groupe alkyle ayant au plus 4 atomes de carbone),
(2) un composé alcoxy-germanium, ayant la formule générale :
Ge(OR)₄
(dans laquelle, R représente un groupe alkyle ayant au plus 4 atomes de carbone) ; et
(3) de l'ozone ; et
b) à introduire le mélange dans la chambre réactionnelle ; et
c) à faire réagir les composés et l'ozone entre eux à la pression atmosphérique de façon à former un mince film de verte sur un substrat.

2. Procédé selon la revendication 1, dans lequel un mince film de verre, composé d'oxyde de silicium et d'oxyde de germanium, est formé sur un substrat.

3. Procédé selon la revendication 1, dans lequel, dans l'étape de mélange, un composé choisi dans le groupe constitué par
(i) un composé alcoxy contenant du phosphore, du bore ou à la fois du phosphore et du bore,
(ii) un oxyde contenant du phosphore, du bore ou à la fois du phosphore et du bore, et
(iii) un chlorure d'acide contenant du phosphore, du bore ou ou à la fois du phosphore et du bore
est mélangé avec ledit composé organosilane et ledit composé alcoxygermanium.

4. Procédé selon la revendication 3, dans lequel ledit composé alcoxy contenant du phosphore du bore ou à la fois du phosphore et du bore est un composé alcoxy exprimé par la formula générale PO(OR)₃ ou P(OR)₃, un composé alcoxy exprimé par la formule générale B(OR)₃, ou un mélange des ces composés alcoxy (dans ces formules, R représente un groupe alkyle ayant au plus 4 atomes de carbone ou un dérivé de celui-ci).

5. Procédé selon la revendication 3, dans lequel un mince feuil de verte, composé d'oxyde de silicium, d'oxyde de germanium et d'oxyde de bore, est formé sur un substrat.

6. Procédé selon la revendication 3, dans lequel un mince feuil de verre, composé d'oxyde de silicium, d'oxyde de germanium et d'oxyde de phosphore, est formé sur un substrat.

7. Procédé selon la revendication 3, dans lequel un mince feuil de verre, composé d'oxyde de silicium, d'oxyde de germanium, d'oxyde de bore et d'oxyde de phosphore, est formé sur un substrat.
